# EUROPEAN PATENT SPECIFICATION

(11) **EP 2 635 877 B1**
(45) Date of publication and mention of the grant of the patent: **21.12.2016**
(21) Application number: 11785464.6
(22) Date of filing: 26.10.2011
(51) Int. Cl.: G01D 4/00

(54) **MODULAR METERING SYSTEM**
MODULARES MESSSYSTEM
SYSTÈME DE MESURE MODULAIRE

(30) Priority: 31.12.2010 GB 201022118; 01.11.2010 GB 201018456
(43) Date of publication of application: 11.09.2013
(73) Proprietor: Northern Design (Electronics) Limited, Bradford, West Yorkshire BD3 0QW (GB)
(72) Inventor: SYKES, Ian, Bradford, West Yorkshire BD3 0QW (GB); CLAY, Paul, Bradford, West Yorkshire BD3 0QW (GB); SZAJDZICKA, Julia, Bradford, West Yorkshire BD3 0QW (GB)
(74) Representative: Mohun, Stephen John
(86) International application number: PCT/GB2011/052077
(87) International publication number: WO 2012/059737

(56) References cited:
- WO-A1-2010/031012
- WO-A2-2005/050586
- US-A1- 2006 161 396

## Description

The present invention relates to a system for metering. The invention is concerned particularly, although not exclusively, with a modular apparatus for metering energy.

Currently in domestic and commercial premises electricity, gas, water and air quality/usage, for example, are monitored using separate stand-alone meters. Particularly in commercial premises the electricity usage of several devices or appliances, hereinafter referred to generally as "loads", is often monitored using separate meters for each load. In such cases, in order to derive valuable data about the energy usage of each load it is necessary to collate metered values manually, and subsequently enter the data manually on a computer for processing.

More sophisticated electricity meters are configured to send data automatically to a data logging device which may be local, or may be reached via a communications device, for example over the telephone line, or the internet.

A previously considered example of electricity meter brings together a fixed number of metering units and combines them in a unitary housing, together with a common visual display and processing means to manipulate and present the data collected by the individual metering units. Cables are used to carry the measurement signals from current detectors located locally at each load. The combined multi-meter load is particularly suited to modern premises in which the electrical supply enters the building at a single location, and is controlled from a single control panel.

Whilst the combined meter units of the prior system allow for data to be obtained and handled, and if necessary transmitted to a remote host, more easily than separate meters, the apparatus is typically supplied as a unit of fixed size, with a fixed number of meter units (usually twelve). When the premises have more loads than can be accommodated on a single multi-meter device it is necessary to install second or further devices, with the number of meter units increasing in multiples of twelve. This can often lead to an installation having many more meters than is necessary for the number of loads, leaving many meter units redundant. Such an inflexible system can therefore be needlessly expensive.

Furthermore, even if there is no, or little, redundancy the system may be unable to accommodate an expansion in the number of loads without requiring considerable further installation work.

Commercial organisations require increasingly large amounts of information about their energy usage in order to assist in the management of costs. Businesses are also seeking to monitor a growing number of different parameters, such as for example water usage, air quality/usage and footfall. Currently the metering or monitoring of electricity, gas, water, air quality and footfall is handled by a diverse array of equipment, and the collection, transmission and presentation of the information is a complex task. In order to capture, where necessary convert or standardise, and then log/transfer the data it is usually necessary to install specifically designed data processing apparatus in the premises. Such apparatus is usually expensive and often lacks versatility, so that it cannot always accommodate a request for a change in the type of information that is to be gathered.

WO 2010/031012 A1 describes a management system for the control of household appliances, in which a single meter communicates with a plurality of appliances to switch the operational mode of the appliances.

WO 2005/050586 A2 describes host-client utility meter systems, and in particular a system in which a host meter device communicates with one or more client meter devices and transmits meter device information to a utility.

US 2006/0161396 A1 describes a system and method for providing an additional option function to existing functionality of a meter device configured for measuring parameters of energy, in which the meter device is coupled with an option device.

Preferred embodiments of the present invention aim to address at least some of the aforementioned shortcomings in the prior systems.

The present invention is defined in the attached independent claims, to which reference should now be made. Further, preferred features may be found in the sub-claims appended thereto.

According to one aspect of the invention there is provided a modular metering system comprising a master module and a plurality of slave modules arranged to measure a parameter, the master module being arranged to communicate electronically with the slave modules.

Preferably the system includes a plurality of slave modules and a plurality of the slave modules comprise an electricity meter. The system may be provided with a communications bus through which the master module may communicate with slave modules.

Alternatively or in addition the system may include means for wireless communication between the master module and the slave modules.

The system may include a communications module arranged to facilitate communication between the master module and a remote host.

The slave modules are preferably arranged for releasable physical engagement with the master module and/or other slave modules. In a preferred arrangement the physical engagement of modules automatically connects a data and/or power bus between them.

The master module is preferably arranged to poll the slave modules.

The polling of the slave modules may be sequential. The slave modules may include a memory, which memory may be arranged to store data including calibration data.

In a preferred arrangement the master module includes a display, which display may be arranged to present information relating to one or more of the slave modules. The display may be controllable so as to allow a user to select the slave module from which information is to be presented. The master module preferably includes a user interface which may comprise an input device, such as a key pad.

Preferably the master module is arranged to calibrate the slave modules.

The master module may be arranged to calibrate a number of slave modules substantially simultaneously. The master module may also comprise power supply means for the slave modules, which power supply means may comprise an auxiliary power supply for the slave modules.

The master module may comprise electronic processing means and/or electronic memory means. The slave modules may comprise electronic processing means and or electronic memory means.

In one preferred arrangement the master unit comprises a data logging means.

The system includes a plurality of electricity meters.

Preferably the system includes one or more slave modules comprising at least one three-phase electricity meter and/or three single-phase electricity meters.

The system may include slave modules arranged to monitor and/or meter parameters including at least one of electricity usage, gas usage, water usage, water quality, steam usage, air quality, air usage and entry/exit by persons through a door.

The invention also includes a method of energy management, comprising measuring and/or monitoring plural parameters using meter and/or monitor slave modules connected to a master module in a system according to any statement herein.

A preferred embodiment of the present invention will now be described by way of example only, with reference to the accompanying diagrammatic drawings in which:
Figure 1 is a schematic perspective view or a modular metering unit according to an embodiment or the invention;
Figure 2 shows the unit of Figure- 1 in partly exploded view; and
Figure 3 is a schematic front view of part of the unit of Figures 1 and 2.

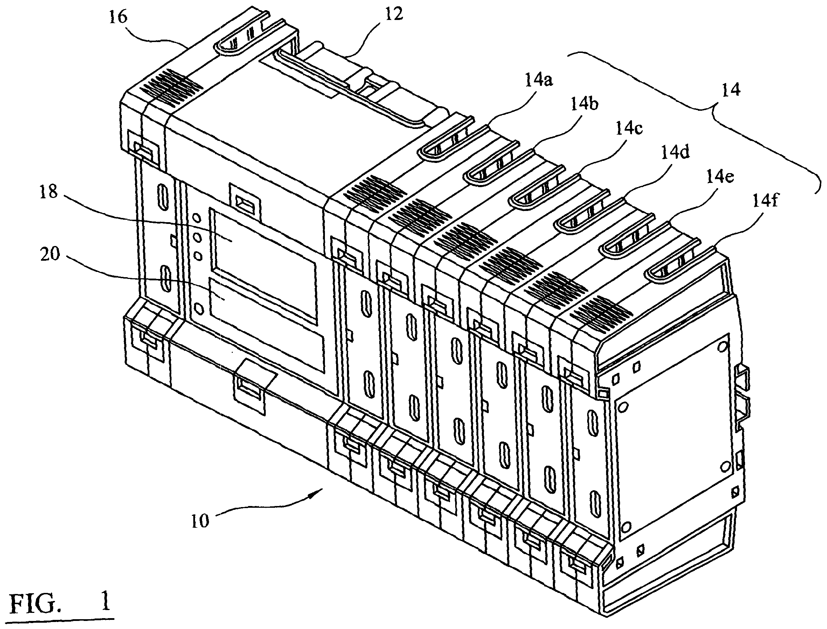

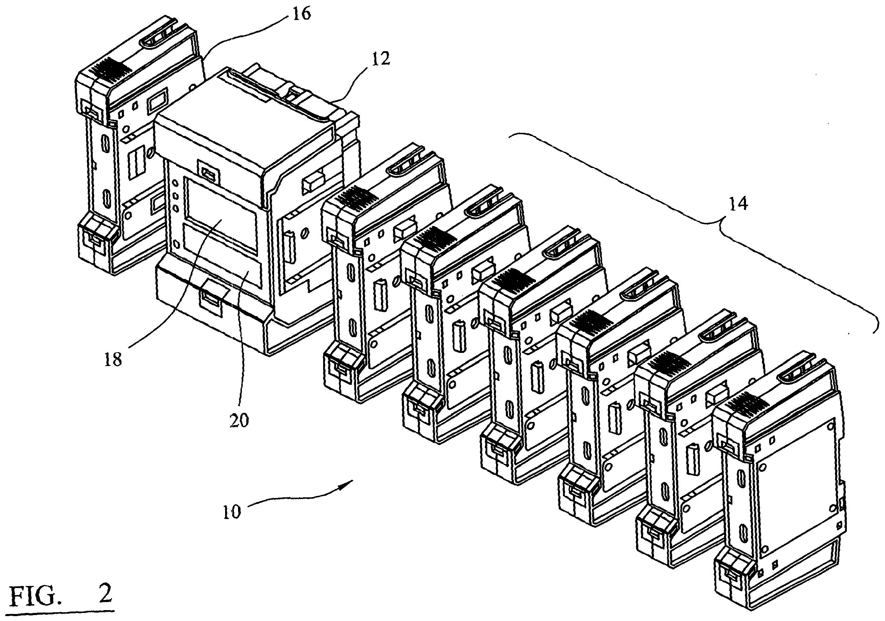

Referring to Figures 1 and 2 these show a modular metering unit generally at 10, comprising a master module 12, slave modules 14a to 14f, and a communications module 16. Together the modules 12, 14 and 16 make up a modular metering unit for metering electricity from plural loads (not shown) such as, in the case of a large food retail premises, chill or freeze display cabinets.

Each or the slave modules includes electricity meters for measuring electricity supplied to a load. The loads may be located remotely from the metering unit and each one has a current detector that feeds a low-voltage signal back to the meter via a cable (not shown).

The slave modules are connected to one another and to the master module by an internal bus through which data and power are carried between the modules.

The master module 12 comprises the hub of the system and communicates on a bespoke internal bus with the slave modules to interface/measure/collect/detect/monitor data relevant to an individual site/application. The master module is arranged to periodically pull data from each slave making it available to a user as though sourced from a single device. An LCD display unit 18 presents the data to a user. The master module also houses a 32-bit microprocessor (not shown) which, with custom firmware, is used to manipulate the data gathered from the slave modules making the data ready for external systems. Concentrating data in this way reduces the time and resource required for external systems to collect and manipulate a range of energy management data.

The display unit 18 can be optionally supplied as a data logger with a built-in real-time clock/calendar. This hardware/software option allows concentrated data from the slave modules 14 to be periodically stored in an internal database which is secure in the event of power failure to the system. Time-stamped logged data may be read remotely by an external energy management system or sent to a remote website for analysis. Secure local storage is the preferred approach for a number of applications such as sub-tenant billing and energy profiling, for example.

The master module 12 also includes an overlay keypad 20, with membrane keys which, together with the display 18, provide a versatile, single-user interface. The user selects a window for each of the slave modules 14 using the keypad 20 thus removing the need for multiple displays. This single user interface also allows setup/configuration of each slave, in addition to viewing its data.

The master module 12 acts as the main auxiliary power supply for the entire system. Mains voltage is connected to the master module where it is isolated and converted to a low level do supply which is made available to the slave modules on the internal interconnecting bus.

High voltage measurement inputs are also connected at the master module, where they are attenuated and made available to any of the slave modules 14 via the internal interconnecting bus. This single connection point for voltage significantly reduces site wiring of the built system when multiple loads are measured.

The firmware in the master module may readily be upgraded in the field to take account of new developments in slave modules, thus making the system future proof.

In the embodiment shown each of the slave modules 14 comprises two, independent, multi-function, electricity meters. These meters measure three phase current via a range of external transducers located at the load, which transducers are selected to suit nominal currents, for example in the range of 5A to 25,000A. Each external transducer provides a safe signal at the measured point which is fed back to the metering system on a pair of wires. Firmware in the individual slave module linearises the measured current and corrects for inherent phase angle and gain errors making the overall system very accurate. The calibrated current signals are combined with the 3-phase voltages, fed from the master module on the Interconnecting bus. The resultant data its manipulated to provide measured parameters of volts, amps, kw and frequency and many derived values such as power factor, kVA, kvar, energy, harmonics, THD, max/min and demand values. A complete set of electricity parameters are made available on request (each second) to the display unit 18, In one embodiment calibration and user configuration settings in a dual-meter slave are provided by the master module/central display unit. This allows a number of metering slaves to be calibrated simultaneously, thereby reducing manufacturing costs significantly. This setup data is stored in the slave and secured during power failure so that slaves can be moved from engagement with one master module to another, allowing each slave to be completely autonomous. A system using master and slave serial numbers/slave types provides a method of tracking slaves, thereby easily facilitating in-system upgrades and maintenance.

Each metering element in the dual slave can be independently configured, by the master module, to measure a 3-phase load or 3 separate single phase loads. This provides flexibility in measuring a combination of load types in a single mains distribution board.

The communications module 16 is connected to the left of the central display unit allowing connection of the modular system as a whole to a host, such as a building energy management system (not shown).

Data from the communication module is transferred to/from the master module via a second, independent internal dsta/power supply bus. A range of communications modules may be supplied, some of which contain additional processing power to provide high speed access to the data in the master module and therefore to the slave module data. Communications modules may be provided for connection to remote hosts via GPRS (mobile phone), Wi-Fi, Zigbee, Ethernet etc.

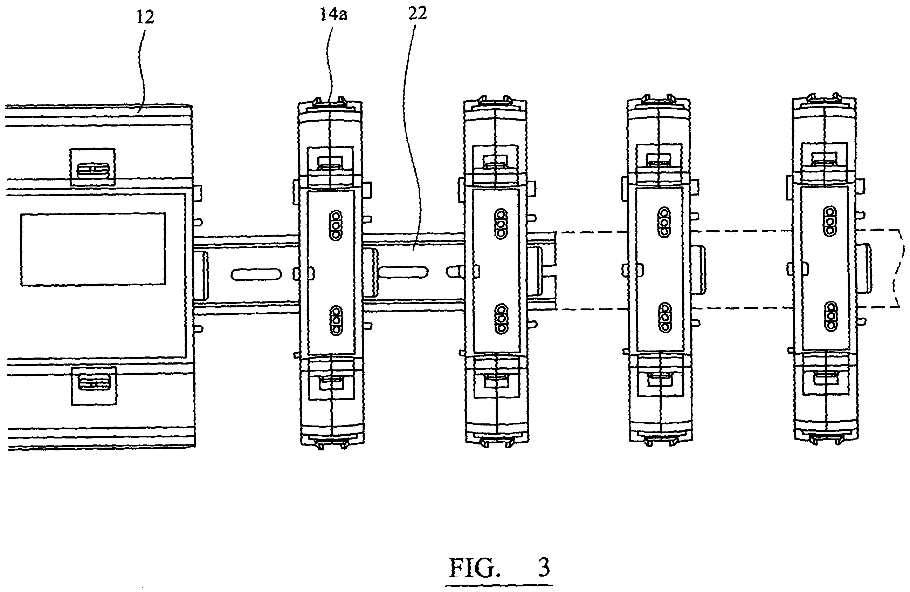

Figure 3 shows part of the unit 10 in exploded view. The individual modules connect together by a releasable snap-fit engagement and each clips on, at its rear, to a DIN rail 22.

Whilst the embodiment shown in the drawings comprises six slave modules, the unit can have more modules or fewer in order to accommodate the specific load requirements of the installation. Since new modules can readily be connected, the system may be expanded as more loads are added. As the modules are snapped together they become physically engaged and at the same time the internal power/data bus becomes connected.

Furthermore, the inherent flexibility of the system allows a range of slave modules of different kinds to function as elements of a complete energy management solution. In embodiments of the present invention the system may combine a number of multi-function electricity meters with other elements of a complete energy management system in a single compact unit. Again, each slave device communicates with the master module on a standard communication/power bus.

Other modular slaves which may be provided include pulse-input collectors, which allow other utility meters such as gas, water, steam and air meters, for example, to feed data into the master display unit. Other energy management parameters may be introduced to the system by using an analogue input module, allowing other quantities/qualities to be metered and/or monitored, via external transducers, including other environmental parameters, such as (but not limited to) temperature indoors, outdoors, of a process, of a liquid. Almost any variable that is measurable by an external transducer may be introduced into the system.

The modular design provides a high degree of flexibility, so that any function desired can be mounted into a module enclosure along with a microprocessor programmed to act as a bridge, via the internal communication bus, between an external function and the master module.

In the embodiment described, up to twenty slave modules 14 (dual metering slave = two modules) can be added to a single master/display 12/16. This includes all slave module types. In the present embodiment this limitation arises from the internal data bus bandwidth and a specification that requires the polling of each slave module every second. Bandwidth may be increased if an increased number of modules are required.

The modular metering system described herein allows a number of advanced smart electricity meters to be connected together along with other elements to form a complete, scalable energy management system which can be tailored to provide a specific required solution.

## Claims

1. A modular metering system comprising a master module (12) and a plurality of slave modules (14) each arranged to measure a parameter, the master module being arranged to communicate electronically with the slave modules, **characterised in that** a plurality of the slave modules (14) comprise electricity meters, each being arranged to measure electricity supplied to a remotely located load, and high voltage measurement signals are provided by the master module (12) to the electricity meters (14).

2. A system according to Claim 1, further comprising a communications bus through which the master module is arranged to communicate with the, or each, slave module.

3. A system according to Claim 1 or 2 further comprising means for wireless communication between the master module and the, or each, slave module.

4. A system according to any of the preceding claims, further comprising a communications module (16) arranged to facilitate communication between the master module and a remote host.

5. A system according to any of the preceding claims, wherein the slave modules are arranged for releasable physical engagement with the master module and/or other slave modules.

6. A system according to Claim 5, wherein the physical engagement of modules is arranged to automatically connect a data and/or power bus between them.

7. A system according to any of the preceding claims, wherein the master module is arranged to poll the, or each, slave module.

8. A system according to Claim 7, wherein the polling of the, or each, slave module is sequential.

9. A system according to any of the preceding claims, wherein the, or each, slave module includes a memory, which memory is arranged to store data including calibration data.

10. A system according to any of the preceding claims, wherein the master module includes a display (18), which display is arranged to present information relating to one or more slave modules.

11. A system according to Claim 10, wherein the display is controllable so as to allow a user to select the slave module from which information is to be presented.

12. A system according to any of the preceding claims, wherein the master module includes a user interface which comprises an input device, such as a key pad (20).

13. A system according to any of the preceding claims, wherein the master module is arranged to calibrate the, or each, slave module.

14. A system according to Claim 13, wherein the master module is arranged to calibrate a number of slave modules substantially simultaneously.

15. A system according to any of the preceding claims, wherein the master module further comprises power supply means for the slave modules, which power supply means comprises an auxiliary power supply for the slave modules.

16. A system according to any of the preceding claims, wherein the master module comprises electronic processing means and/or electronic memory means.

17. A system according to any of the preceding claims, wherein the, or each, slave module comprises electronic processing means and/or electronic memory means.

18. A system according to any of the preceding claims wherein the master unit comprises a data logging means.

19. A system according to any of the preceding claims including one or more slave modules comprising at least one three-phase electricity meter and/or three single-phase electricity meters.

20. A system according to any of the preceding claims including one or more slave modules arranged to monitor and/or meter parameters including at least one of electricity usage, gas usage, water usage, water quality, steam usage, air quality, air usage and entry/exit by persons through a door.

21. A method of energy management, comprising measuring and/or monitoring plural parameters using meter and/or monitor slave modules connected to a master module in a system according to any of claims 1 to 20.

## Patentansprüche

1. Modulares Dosierungssystem, umfassend ein Master-Modul (12) und eine Anzahl von Slave-Modulen (14), die jeweils eingerichtet sind, um einen Parameter zu messen, wobei das Master-Modul eingerichtet ist, elektronisch mit den Slave-Modulen zu kommunizieren, **dadurch gekennzeichnet, dass** eine Anzahl der Slave-Module (14) Elektrizitätsmesser umfassen, die jeweils angeordnet sind, um Elektrizität zu messen, die einer entfernt angeordneten Last zugeführt wird, wobei Hochspannungs-Messsignale von dem Master-Modul (12) für die Elektrizitätsmesser (14) zur Verfügung gestellt werden.

2. System nach Anspruch 1, weiter umfassend einen Kommunikationsbus, durch den das Master-Modul eingerichtet ist, um mit dem oder mit jedem Slave-Modul zu kommunizieren.

3. System nach Anspruch 1 oder 2, weiter umfassend ein Mittel für eine drahtlose Kommunikation zwischen dem Master-Modul und dem oder jedem Slave-Modul.

4. System nach einem der vorangehenden Ansprüche, weiter umfassend ein Kommunikationsmodul (16), das eingerichtet ist, um eine Kommunikation zwischen dem Master-Modul und einem entfernt angeordneten Host zu ermöglichen.

5. System nach einem der vorangehenden Ansprüche, **dadurch gekennzeichnet, dass** die Slave-Module für ein lösbares physikalisches Zusammenwirken mit dem Master-Modul und/oder mit anderen Slave-Modulen eingerichtet sind.

6. System nach Anspruch 5, **dadurch gekennzeichnet, dass** das physikalische Zusammenwirken von Modulen für eine automatische Verbindung eines Daten- und/oder Stromversorgungsbus zwischen diesen eingerichtet ist.

7. System nach einem der vorangehenden Ansprüche, **dadurch gekennzeichnet, dass** das Master-Modul eingerichtet ist, um das oder jedes Slave-Modul abzufragen.

8. System nach Anspruch 7, **dadurch gekennzeichnet, dass** die Abfrage des oder jedes Slave-Moduls sequenziell erfolgt.

9. System nach einem der vorangehenden Ansprüche, **dadurch gekennzeichnet, dass** das oder jedes Slave-Modul einen Speicher umfasst, wobei der Speicher eingerichtet ist, um Daten, einschließlich Kalibrierungsdaten, zu speichern.

10. System nach einem der vorangehenden Ansprüche, **dadurch gekennzeichnet, dass** das Master-Modul eine Anzeige (18) umfasst, wobei die Anzeige eingerichtet ist, um Informationen anzuzeigen, die sich auf ein oder mehrere Slave-Module beziehen.

11. System nach Anspruch 10, **dadurch gekennzeichnet, dass** die Anzeige steuerbar ist, um einem Benutzer zu ermöglichen, dasjenige Slave-Modul auszuwählen, von dem Informationen präsentiert werden sollen.

12. System nach einem der vorangehenden Ansprüche, **dadurch gekennzeichnet, dass** das Master-Modul ein Benutzerinterface umfasst, das eine Eingabeeinrichtung umfasst, wie etwa ein Keyboard (20).

13. System nach einem der vorangehenden Ansprüche, **dadurch gekennzeichnet, dass** das Master-Modul eingerichtet ist, um das oder jedes Slave-Modul zu kalibrieren.

14. System nach Anspruch 13, **dadurch gekennzeichnet, dass** das Master-Modul eingerichtet ist, um eine Anzahl von Slave-Modulen im Wesentlichen gleichzeitig zu kalibrieren.

15. System nach einem der vorangehenden Ansprüche, **dadurch gekennzeichnet, dass** das Master-Modul weiterhin eine Stromversorgungseinrichtung für die Slave-Module umfasst, wobei die Stromversorgungseinrichtung eine Hilfsstromversorgung für die Slave-Module umfasst.

16. System nach einem der vorangehenden Ansprüche, **dadurch gekennzeichnet, dass** das Master-Modul eine elektronische Verarbeitungseinrichtung und/oder eine elektronische Speichereinrichtung umfasst.

17. System nach einem der vorangehenden Ansprüche, **dadurch gekennzeichnet, dass** das oder jedes Slave-Modul eine elektronische Verarbeitungseinrichtung und/oder eine elektronische Speichereinrichtung umfasst.

18. System nach einem der vorangehenden Ansprüche, **dadurch gekennzeichnet, dass** die Mastereinheit eine Datenprotokollierungseinrichtung umfasst.

19. System nach einem der vorangehenden Ansprüche, mit einem oder mehreren Slave-Modulen, umfassend zumindest eine dreiphasige Elektrizitätsmesseinrichtung und/oder drei einphasige Elektrizitätsmesseinrichtungen.

20. System nach einem der vorangehenden Ansprüche, mit einem oder mehreren Slave-Modulen, die eingerichtet sind, um Parameter zu überwachen und/oder zu messen, umfassend zumindest einen von Elektrizitätsverbrauch, Gasverbrauch, Wasserverbrauch, Wasserqualität, Dampfverbrauch, Luftqualität, Luftverbrauch und Eintritt/Austritt von Personen durch eine Tür.

21. Verfahren zum Energiemanagement, umfassend das Messen und/oder Überwachen von mehreren Parametern unter Verwendung von Mess- und/oder Überwachungs-Slave-Modulen, die mit einem Master-Modul verbunden sind, in einem System nach einem der Ansprüche 1 bis 20.

## Revendications

1. Dispositif de mesure modulaire comprenant un module maître (12) et une pluralité de modules esclaves (14), chacun étant agencé de manière à mesurer un paramètre, le module maître étant agencé de manière à communiquer électroniquement avec les modules esclaves, **caractérisé en ce qu'**une pluralité des modules esclaves (14) comprend des compteurs électriques, chacun étant agencé de manière à mesurer la quantité d'électricité délivrée à une charge située à distance, et des signaux de mesure à haute tension sont délivrés par le module maître (12) aux compteurs électriques (14).

2. Dispositif selon la revendication 1, comprenant en outre un bus de communication par l'intermédiaire duquel le module maître est agencé de manière à communiquer avec le ou chaque module esclave.

3. Dispositif selon la revendication 1 ou 2, comprenant en outre un élément de communication sans fil entre le module maître et le ou chaque module esclave.

4. Dispositif selon l'une quelconque des revendications précédentes, comprenant en outre un module de communication (16) agencé de manière à faciliter la communication entre le module maître et un hôte distant.

5. Dispositif selon l'une quelconque des revendications précédentes, dans lequel les modules esclaves sont agencés de manière à assurer un couplage physique amovible avec le module maître et/ou d'autres modules esclaves.

6. Dispositif selon la revendication 5, dans lequel le couplage physique de modules est agencé de manière à coupler automatiquement un bus de données et/ou de puissance entre eux.

7. Dispositif selon l'une quelconque des revendications précédentes, dans lequel le module maître est agencé de manière à scruter le ou chaque module esclave.

8. Dispositif selon la revendication 7, dans lequel la scrutation du ou de chaque module esclave est séquentielle.

9. Dispositif selon l'une quelconque des revendications précédentes, dans lequel le ou chaque module esclave comporte une mémoire, laquelle mémoire est agencée de manière à mémoriser des données comportant des données d'étalonnage.

10. Dispositif selon l'une quelconque des revendications précédentes, dans lequel le module maître comporte un dispositif d'affichage (18), lequel dispositif d'affichage est agencé de manière à présenter des informations concernant un ou plusieurs modules esclaves.

11. Dispositif selon la revendication 10, dans lequel le dispositif d'affichage peut être commandé de manière à permettre à un utilisateur de sélectionner le module esclave à partir duquel les informations doivent être présentées.

12. Dispositif selon l'une quelconque des revendications précédentes, dans lequel le module maître comporte une interface d'utilisateur qui comprend un dispositif d'entrée, tel un clavier (20).

13. Dispositif selon l'une quelconque des revendications précédentes, dans lequel le module maître est agencé de manière à étalonner le ou chaque module esclave.

14. Dispositif selon la revendication 13, dans lequel le module maître est agencé de manière à étalonner un certain nombre de modules esclaves de façon sensiblement simultanée.

15. Dispositif selon l'une quelconque des revendications précédentes, dans lequel le module maître comprend en outre un moyen d'alimentation en énergie pour les modules esclaves, lequel moyen d'alimentation en énergie comprend une source d'énergie auxiliaire pour les modules esclaves.

16. Dispositif selon l'une quelconque des revendications précédentes, dans lequel le module maître comprend un moyen de traitement électronique et/ou un moyen de mémorisation électronique.

17. Dispositif selon l'une quelconque des revendications précédentes, dans lequel, le ou chaque module esclave comprend un moyen de traitement électronique et/ou un moyen de mémorisation électronique.

18. Dispositif selon l'une quelconque des revendications précédentes dans lequel l'unité maître comprend un moyen d'enregistrement numérique.

19. Dispositif selon l'une quelconque des revendications précédentes comportant un ou plusieurs modules esclaves comprenant au moins un compteur électrique triphasé et/ou trois compteurs électriques monophasés.

20. Dispositif selon l'une quelconque des revendications précédentes comportant un ou plusieurs modules esclaves agencés de manière à surveiller et/ou mesurer des paramètres comportant au moins l'un parmi une utilisation d'électricité, une utilisation de gaz, une utilisation d'eau, une qualité de l'eau, une utilisation de vapeur, une qualité d'air, une utilisation d'air et une entrée/sortie de personnes par une porte.

21. Procédé de gestion d'énergie, comprenant la mesure et/ou le contrôle de plusieurs paramètres en utilisant des modules esclaves de mesure et/ou de contrôle couplés à un module maître dans un dispositif selon l'une quelconque des revendications 1 à 20.
